# EUROPÄISCHE PATENTANMELDUNG

(11) **EP 2 224 267 A2**
(43) Veröffentlichungstag der Anmeldung: **01.09.2010**
(21) Anmeldenummer: 10153838.7
(22) Anmeldetag: 17.02.2010
(51) Int. Cl.: G01V 3/10

(54) **Betriebsverfahren und Spulenanordnung für einen magnetischen Sensor zur Detektion metallischer Objekte in einem Untergrund**

(30) Priorität: 27.02.2009 DE 102009010943
(71) Anmelder: HILTI Aktiengesellschaft, 9494 Schaan (LI)
(72) Erfinder: Gogolla, Torsten, 9494, Schaan (LI); Würsch, Christoph, 9470, Werdenberg (CH); John, Andreas, 8892, Berschis (CH)

(57) **Zusammenfassung**

Erfindungsgegenstand ist eine Spulenanordnung für einen magnetischen Sensor zur Detektion von metallischen Objekten in einem Untergrund, insbesondere von Bauwerken aus Beton, Ziegel, Holz und dergleichen sowie ein Verfahren zum Bestromen und Auslesen dieser Spulenanordnung. Um einerseits ein hohe Messtiefe und andererseits ein gutes Separationsvermögen für mögliche zu erkennende Objekte zu erreichen umfasst die Spulenanordnung eine bzw. vorzugsweise zwei übereinander liegende äußere Hauptspulen (B_{L}, B_{U}) über die eine senkrechte magnetische Durchflutung des Untergrunds bewirkt wird. Innerhalb der äußeren Hauptspule(n) ist einerseits ein Quartett von insgesamt zwei Paaren von symmetrisch zur Achse der Hauptspule(n) liegenden Parallelspulen (I1, I2; Q1, Q2) vorgesehen, über das zur Erkennung von verschweißten Gittern und ferritischen Untergründen, zur Differenzierung zwischen Eisen und Nicht-Eisenobjekten, zur Lokalisierung von Stäben verschweißter Gitter und zur Verbesserung der Überdeckungsschätzung und Lokalisierung von Objekten in geringer Tiefe eine Durchflutungsdurchdringung des Untergrunds in zwei Richtungen parallel zur Untergrundoberfläche möglich ist. Zur weiteren Verbesserung von Genauigkeit und Zuverlässigkeit der Objektlokalisierung und Überdeckungsschätzung sind außerdem zwei Paare von jeweils einander gegenüberstehenden und ebenfalls symmetrisch zur Achse der Hauptspule(n) angeordnete kleinere Orthogonalspulen (VI1, VI2; VQ1, VQ2) vorgesehen. In einem vollständigen Messzyklus werden sowohl die Hauptspule(n) als auch die innen liegenden Horizontal- bzw. Orthogonalspulen monostatisch und wechselweise bistatisch betrieben mit ratiometrischer Auswertung der gewonnenen Messsignale.

## Beschreibung

Die Erfindung betrifft eine Spulenanordnung für einen magnetischen Sensor zur Detektion von metallischen Objekten in einem Untergrundmedium also zur Lokalisierung und/oder Überdeckungsmessung von beispielsweise in Wänden, Böden und Decken eingebetteten elektrisch leitfähigen Objekten wie Armierungseisen, Kupferrohren, Spannkabeln, Doppel-T-Trägern, Platten, Gittern etc. in gängigen Untergründen von Bauwerken z. B. Beton, Ziegel, Holz, Gips usw.

Innerhalb der Internationalen Patentklasse G01V3/08-12 ist eine Vielzahl von Vorschlägen für die Erfassung von in Untergründen vergrabenen Objekten bekannt, wobei nur beispielshalber auf die EP 1092989 B1, DE 699 35 792 T2, DE 3615652 C2, DE 1012274 A1 und US 5,557,206 hingewiesen wird.

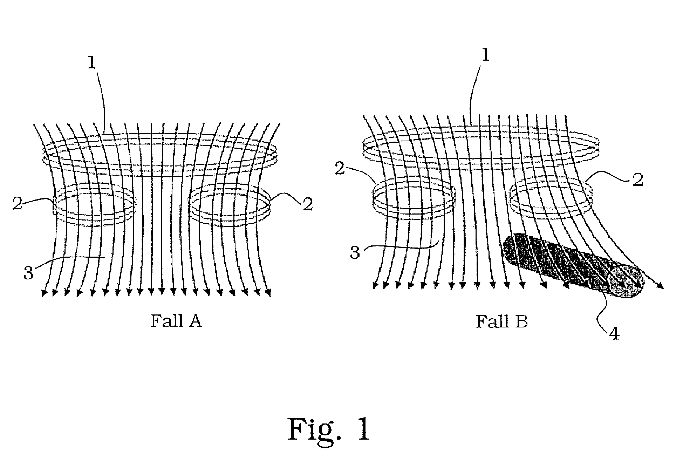

Zur Objekterfassung im oben umrissenen Sinn wird im Prinzip mit einer Spule ein starkes magnetisches Primärfeld in den Untergrund induziert, das dort mit eventuell vorhandenen metallischen Objekten wechselwirkt. Die Fig. 1 der beigefügten Zeichnungen veranschaulicht einen allgemeinen Fall, bei der eine Primär- oder Erregerspule 1 ein starkes periodisches Magnetfeld 3 generiert, welches im Falle eines objektfreien Untergrunds in einer oder mehreren zur Achse des Magnetfelds 3 symmetrisch stehenden Empfängerspulen 2 keine Feldasymmetrie erzeugt (Fall A) während bei einem vorhandenen (Eisen-)Objekt 4 eine über die Empfängerspulen 2 registrierbare Feldveränderung feststellbar ist (Fall B). Diese Wechselwirkung äußert sich einerseits darin, dass bei permeablen Objekten 4, insbesondere solchen aus Eisen, durch Flussführungseffekte die magnetischen Feldlinien in Richtung zum Eisen abgelenkt werden, da sie dem Weg des geringsten magnetischen Widerstands folgen. Die hierdurch entstehende Feldasymmetrie kann differentiell gemessen werden. Befindet sich beispielsweise, wie im Fall B von Fig. 1 dargestellt, ein Eisenobjekt 4 im Untergrund, so ändern sich dort die Winkel der Feldlinien und damit die von der rechten Empfängerspule gemessene Induktionsspannung. Zwischen der linken und der rechten der beiden Empfängerspulen 2 entsteht also eine Induktionsspannungsdifferenz von ungleich Null. Diese Differenz ist ein Maß für die Position und Tiefe des Objekts 4.

Andererseits erzeugt ein starkes, zeitlich schnell abklingendes Primärfeld 3 (vgl.

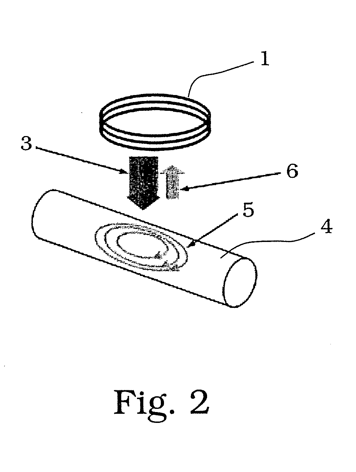

Fig. 2) in metallischen Objekten 4 Wirbelströme 5, die ein verzögertes, relativ schwaches und langsam abklingendes Sekundärfeld 6 generieren. Das abklingende Wirbelstrommagnetfeld 6 kann von Spulen, insbesondere auch über die gleichzeitig als Empfängerspule dienende Erregerspule 1 gemessen werden und enthält Information zu Position und Tiefe des Objekts 4. Bei impulsförmiger Erregung kann die Wirbelstromantwort direkt erfasst werden weil das Primärfeld 3 sehr schnell (in wenigen Mikrosekunden) abgeklungen ist, während das sekundäre Wirbelstromfeld 6 in Abhängigkeit von der Tiefe des Objekts 4, der Objektgröße und den Materialeigenschaften des Objekts 4 deutlich langsamer abklingt. Die Messung der Wirbelstromantwort erfolgt also nach dem Abklingen des Primärfeldes 3. Bei harmonischer Erregung beeinflusst das sekundäre Wirbelstrommagnetfeld 6 das Primärfeld 3, so dass wieder Feldasymmetrien entstehen, die wie oben bereits erwähnt, in Empfängerspulen Induktionsspannungsänderungen bewirken.

Die Induktionsspannungsänderung kann sowohl monostatisch als auch bistatisch gemessen werden. Bei einer monostatischen Messung wird mit derselben Spule sowohl erregt als auch gemessen. Bei einer bistatischen Messung sind die Erregerspule(n) und die Empfängerspulen(n) verschieden (vgl. nur beispielshalber DE 69935792T2, EP 1092989 B1, DE 19122741 A1). Die Detektion von in Bauwerksuntergründen eingebetteten Objekten erfolgt bei den hier beschriebenen handgeführten Sensoren durch mehrfaches Überstreichen oder Überwischen der Stelle, an der das eingebettete Objekt vermutet wird. Dabei lassen sich mit einem Überstreichen erheblich zuverlässigere Lokalisierungsergebnisse erzielen als mit einem punktuelles Aufsetzen des Sensors.

Derzeit bekannte Messgeräte zur Detektion metallischer Objekte in einem Untergrund besitzen vergleichsweise einfache Spulenanordnungen mit nur wenigen Spulen. Die Möglichkeiten zur magnetischen Untergrunddurchflutung sind dabei hinsichtlich Richtung und Form des Magnetfelds begrenzt und damit auch die Möglichkeiten zur Objekterkennung sowie zur Tiefen- und Lagebestimmung. Insbesondere die Messung über verschweißten Gittern, wie sie vor allem in Betonuntergründen verwendet werden, bereitet existierenden Geräten Probleme, weil bei einer magnetischen Durchflutung von oben (vgl. Figur 1) mindestens in einer gesamten Masche Wirbelströme angeregt werden, die gegenüber den innerhalb der einzelnen Gitterstäbe selbst erzeugten Wirbelströmen dominieren können, so dass deren Lokalisierung und sichere Erkennung unzuverlässig bzw. unmöglich ist. Zudem beeinflussen permeable Untergründe wie z.B. eisenoxidhaltiger Ziegel oder magnetidhaltiger Beton die Magnetflussführung und damit auch die messbare Induktionsspannung zusätzlich. Ein zuverlässiges Lokalisieren und eine Überdeckungsmessung sind in solchen Fällen in der Regel unmöglich.

Der Erfindung liegt damit die Aufgabe zugrunde, eine Spulenanordnung und ein Betriebsverfahren zur Detektion von metallischen Objekten in Untergründen zur Verfügung zu stellen, mit denen sich eine Lokalisierung und/oder Überdeckungsmessung von in dem Untergrund vergrabenen Objekten wesentlich genauer und zuverlässiger erreichen lässt als dies bisher möglich war.

Die Erfindung geht von der zunächst aufgrund von Erfahrungen mit bekannten Messgeräten gewonnenen Erkenntnis aus, dass ein gutes Separationsvermögen bei gleichzeitig hoher Messtiefe mit nur einer Durchflutungsart nicht möglich ist, weil Spulen mit hoher Messtiefe schlechte Separationseigenschaften haben. Eine Separation von dicht beisammen liegenden Objekten in einer mittleren Tiefe zwischen etwa 50 mm bis etwa 80 mm ist daher üblicherweise nicht realisierbar. Schmale ovale Spulenformen wie sie in DE 69935792 T2 erwähnt sind, insbesondere solche mit einer hohen Elliptizität, würden zwar beide Anforderungen erfüllen, nicht jedoch die gleichzeitige Forderung nach Rotations- bzw. Orientierungsunabhängigkeit des Sensors, d.h. die Unabhängigkeit des Messergebnisses von der Orientierung der Spulenanordnung bezogen auf die Orientierung der eingebetteten Objekte bzw. bezogen auf die Bewegungsrichtung des Sensors. Auch sind die Zuverlässigkeit der Objektlokalisierung und die Überdeckungsmessung bei unpassender Orientierung des Sensors stark beschränkt.

Mit der Erfindung wird eine Spulenanordnung für magnetische Sensoren zur Detektion von metallischen Objekten in Untergründen bereitgestellt, sowie ein Messverfahren angegeben, mit denen sich die oben erläuterten Einschränkungen wie sie bei bisher bekannten Messgeräten der hier in Rede stehenden Art beobachtet wurden, beseitigt werden. Insbesondere werden für unterschiedliche, beispielsweise nacheinander ablaufende Messaufgaben optimal angepasste magnetische Durchflutungsarten, aber auch Empfangscharakteristiken ermöglicht.

Gemäß einer Ausführungsform umfasst ein magnetischer Sensor zur Detektion von metallischen Objekten in einem Untergrundmedium eine Spulenanordnung mit einer Hauptspule, deren Windungsebene oder Windungsfläche bzw. -ebenen im Wesentlichen parallel zu einer Bewegungsoberfläche des Sensors ausgerichtet ist (sind), wobei das Untergrundmedium senkrecht zur Bewegungsoberfläche des Sensors magnetisch durchflutet wird. Die Bewegungsoberfläche ist dabei eine bei fachgerechter Benutzung des Sensors im Wesentlichen parallel zum Untergrundmedium orientierte Oberfläche des Sensors, die üblicherweise eben ist.

Im Folgenden wird als Windungsebene diejenige Ebene bezeichnet, auf der die Windungen der Spule senkrecht projiziert werden. Die Wickelfläche bezeichnet die von den projizierten Windungen umschlossene Fläche in der Windungsebene. Im Falle einer zylindrischen Spule ist die Wickelfläche deren Grundfläche, d.h. die Fläche, die von der untersten Windungslage umrandet wird. Die beidseitige vertikale Projektion der Wickelfläche definiert einen erweiterten Wickelzylinder, dessen Länge nicht auf die Länge des Spulenkörpers beschränkt ist und dessen obere und untere Grundfläche parallel zur Wickelfläche definiert sind. Die Länge des Wickelzylinders kann den Spulenkörper nach oben und/oder nach unten übersteigen, bspw. symmetrisch zu einer zur Windungsebene parallelen Symmetrieebene des Spulenkörpers. Gemäß einer Gruppe von Ausführungsformen kann der Wickelzylinder mit der Oberkante und/oder der Unterkante des Spulenkörpers oder des Wickelkörpers abschließen.

Im Innenraum des erweiterten Wickelzylinders der ersten Hauptspule sind mindestens zwei Spulen einer ersten Spulengruppe vorgesehen, deren Windungsebenen in einem Winkel zwischen - 90° bis + 90° zur Windungsebene der ersten Hauptspule geneigt sein können. Gemäß einer Ausführungsform sind die Windungsebenen der Spulen der ersten Spulengruppe parallel zur Windungsebene der ersten Hauptspule ausgerichtet. Gemäß einer weiteren Gruppe von Ausführungsformen befinden sich die Spulen der ersten Spulengruppe vollständig oder zu einem überwiegenden Teil im Innenraum des Spulenkörpers der ersten Hauptspule. Unabhängig vom tatsächlichen Winkel zwischen den Windungsebenen der ersten Hauptspule und der Spulen der ersten Spulengruppe werden die Spulen der ersten Spulengruppe im Folgenden auch kurz als "Parallelspulen" bezeichnet. Die erste Spulengruppe kann mehrere, z.B. eine geradzahlige Anzahl, beispielsweise zwei, vier, sechs oder mehr Spulen umfassen, die jeweils paarweise an einer Hauptachse des erweiterten Wickelzylinders der ersten Hauptspule einander gegenüberliegend angeordnet sind. Bevorzugt sind zumindest die Spulen eines jeden einzelnen Spulenpaares von der Hauptachse des erweiterten Wickelzylinders der ersten Hauptspule gleich beabstandet. Gemäß einer weiteren Ausführungsform haben alle Spulen der ersten Spulengruppe denselben Abstand zur Hauptachse.

Die Spulenanordnung umfasst zudem mindestens zwei weitere im Innenraum des erweiterten Wickelzylinders der ersten Hauptspule angeordnete Spulen einer zweiten Spulengruppe, deren Windungsebenen andere Winkel gegenüber der Windungsebene der ersten Hauptspule einnehmen als die Windungsebenen der Spulen der ersten Spulengruppe. Gemäß einer Ausführungsform stehen die Windungsebenen der Spulen der zweiten und die der ersten Spulengruppe orthogonal zueinander. Gemäß einer weiteren Ausführungsform stehen die Windungsebenen der zweiten Spulengruppe orthogonal zur Windungsebene der ersten Hauptspule. Gemäß einer weiteren Gruppe von Ausführungsformen befinden sich die Spulen der zweiten Spulengruppe vollständig oder zum überwiegenden Teil im Innenraum des Spulenkörpers der ersten Hauptspule. Unabhängig vom tatsächlichen Winkel zwischen den Windungsebenen der Spulen der ersten und zweiten Spulengruppe bzw. zwischen den Windungsebenen der Spulen der zweiten Spulengruppe und der Hauptspule werden die Spulen der zweiten Spulengruppe im Folgenden auch kurz als "Orthogonalspulen" bezeichnet. Ähnlich wie die erste Spulengruppe kann auch die zweite Spulengruppe eine geradzahlige Anzahl von Spulen, beispielsweise zwei, vier, sechs oder mehr Spulen umfassen, die jeweils paarweise an einer Hauptachse der Hauptspule einander gegenüberliegend angeordnet sind. Bevorzugt sind die Spulen eines jeden einzelnen Spulenpaares von der Hauptachse der Hauptspule gleich beabstandet. Gemäß einer weiteren Ausführungsform haben alle Spulen der zweiten Spulengruppe denselben Abstand zur Hauptachse.

Die Spulen der ersten und zweiten Spulengruppe können insoweit kleiner als die erste Hauptspule sein, als ihre Wickelflächen kleiner sein können als die Wickelfläche der ersten Hauptspule.

Gemäß einer Ausführungsform ist die Hauptspule als rotationssymmetrische Spule, zum Beispiel als rotationssymmetrische Flachspule ausgestaltet, wobei die Hauptachse auf die Symmetrieachse der rotationssymmetrischen Spule fällt.

Zur Verbesserung der Sensoreigenschaften hinsichtlich der Objektlokalisierung, der Überdeckungsmessung, der Erkennung von ferritischen Untergründen sowie von Gitterstrukturen, z.B. von verschweißten Gittern, und der Bestimmung der Orientierung eingebetteter Objekte ist es vorteilhaft, wenn jeweils zwei der mindestens zwei Spulen der ersten Spulengruppe ("Parallelspulen") einander gegenüberliegend angeordnet und elektrisch derart miteinander verbunden sind, dass ihre Erregerströme zueinander gegensinnig verlaufen, so dass deren Magnetfelder ein im Untergrund zwischen den beiden Spulen eingebettetes Objekt im Wesentlichen horizontal und in derselben Richtung durchfluten. Beispielsweise umfasst die erste Spulengruppe vier Spulen ("Parallelspulen") mit gleicher Windungsebene im Winkelabstand von jeweils 90° und gleichabständig zur Hauptachse der Hauptspule. Zur Verbreiterung der von den kleineren Parallelspulen ausgehenden horizontalen Durchflutung kann es vorteilhaft sein, die Spulen der ersten Spulengruppe oval bzw. elliptisch zu wickeln, wobei die Nebenachsen der Spulen jeweils gegenüberliegend paarweise gleich ausgerichtet sind. Die Spulen der ersten Spulengruppe haben z.B. jeweils im Wesentlichen dieselbe Wickelfläche und/oder dieselbe Induktivität.

Die zweite Spulengruppe umfasst beispielsweise vier Spulen ("Orthogonalspulen") gleicher Größe und Induktion, deren Windungsflächen jeweils senkrecht zueinander und parallel zur Hauptachse des Sensors und damit parallel zur Hauptachse der Hauptspule ausgerichtet stehen.

Die Spulen der zweiten Spulengruppe können zwischen der Hauptachse und den Spulen der ersten Spulengruppe angeordnet sein. Beispielsweise können vier Orthogonalspulen innerhalb der Parallelspulen, mit gleichem Abstand und symmetrisch zur Achse der Hauptspule eng zueinander beabstandet angeordnet sein.

Ein besonderer Vorteil bei der besseren Erkennung insbesondere von tiefer liegenden Objekten ergibt sich dann, wenn die Spulenanordnung eine zweite Hauptspule mit zur ersten Hauptspule paralleler Windungsebene umfasst, die bezogen auf die Bewegungsoberfläche des Sensors unterhalb, bevorzugt aber oberhalb der ersten Hauptspule angeordnet ist. Die zweite Hauptspule ist beispielsweise eine rotationssymmetrische Spule, etwa eine rotationssymmetrische Flachspule, deren Durchmesser etwas kleiner oder größer als der Durchmesser der (ersten) Hauptspule ist, so dass sich deutlich unterschiedliche Signalsignaturen ergeben, die eine bessere Überdeckungsschätzung ermöglichen. Beispielsweise liegt der Durchmesser der ersten Hauptspule zwischen etwa 50 mm und etwa 150 mm, vorzugsweise zwischen etwa 80 mm und etwa 100 mm. Der Durchmesser der zweiten Hauptspule ist beispielsweise etwa 10 mm kleiner oder größer als der Durchmesser der ersten Hauptspule.

Für flächenmäßig größere Sensoren der hier in Rede stehenden Art kann es zur weiteren Erhöhung der Auflösung bei der Erkennung von Objekten in Untergründen vorteilhaft sein, eine Reihenanordnung mehrerer der oben beschriebenen Spulenanordnungen vorzusehen. Insbesondere kann die Spulenanordnung eine Reihenanordnung von mehreren, jeweils gleich gruppierten Parallelspulen und/oder Orthogonalspulen umfassen, wobei diese Reihenanordnung durch eine oder zwei gemeinsame Hauptspule(n) umschlossen wird.

Im Folgenden werden Einzelheiten zu einer Spulenanordnung und zum Betrieb einer Spulenanordnung mit erfindungsgemäßen Merkmalen anhand von Ausführungsbeispielen näher erläutert.
- **Fig. 1**: veranschaulicht anhand einer bereits erläuterten Prinzipskizze die Wechselwirkung eines durch eine Erregerspule in einem Untergrund generierten magnetischen Feldes mit einem im Untergrund eingebetteten permeablen Objekt aus z.B. Eisen.
- **Fig. 2**: veranschaulicht anhand einer bereits erläuterten Prinzipskizze die Erzeugung eines durch Wirbelströme in einem im Untergrund eingebetteten permeablen Objekt entstehenden sekundären Magnetfelds, aus dessen Eigenschaften Position und Tiefe des Objekts ableitbar sind.
- **Fig. 3A**: ist eine schematische Draufsicht auf eine Spulenanordnung gemäß einer Ausführungsform der Erfindung.
- **Fig. 3B**: ist eine vereinfachte schematische Querschnittsansicht der beiden Hauptspulen der Ausführungsform gemäß Fig. 3A.
- **Fig. 3C**: ist eine vereinfachte schematische Querschnittsansicht zweier Spulen einer ersten Spulengruppe der Ausführungsform gemäß Fig. 3A.
- **Fig. 4**: ist eine perspektivische Darstellung eines Kopfes eines Sensors bzw. Spulenkörpers für eine Spulenanordnung nach Fig. 3A gemäß einer weiteren Ausführungsform der Erfindung;
- **Fig. 5**: ist eine schematische Draufsicht auf eine Spulenanordnung mit paarweiser Reihenanordnung von jeweils vier Spulenanordnungen nach Fig. 3A gemäß einer weiteren Ausführungsform der Erfindung;
- **Fig. 6**: ist eine schematische Draufsicht auf eine Anordnung mit einer länglichen Hauptspule und vier im Innenraum der Hauptspule in einer Reihe angeordneten Gruppen von jeweils vier Parallel- und Orthogonalspulen gemäß einer weiteren Ausführungsform der Erfindung.
- **Fig. 7**: ist eine schematische Draufsicht auf eine Anordnung mit einer kreisförmigen Hauptspule und vier im Innenraum der Hauptspule angeordneten Gruppen von jeweils vier Parallel- und Orthogonalspulen gemäß einer weiteren Ausführungsform der Erfindung.
- **Fig. 8**: ist ein schematisches Blockschaltbild eines Sensors mit zwei in derselben Ebene angeordneten Paaren von Parallelspulen gemäß einer anderen Ausführungsform der Erfindung.
- **Fig. 9**: ist ein schematisches Blockschaltbild eines Sensors mit vier auf zwei Ebenen verteilten Paaren von Parallelspulen gemäß einer weiteren Ausführungsform der Erfindung.

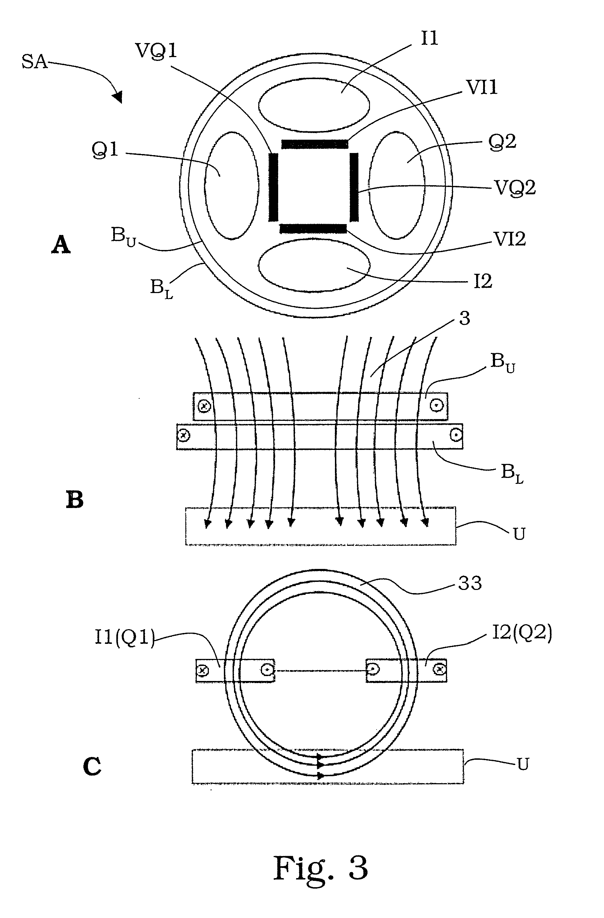

Die anhand der Fig. 3A bis Fig. 3C dargestellte Spulenanordnung SA umfasst eine erste Hauptspule B_{L}, welche einen zu untersuchenden Untergrund und in diesem eingebettete Messobjekte von oben und in senkrechter Richtung zur Oberfläche des Untergrunds durchflutet (vgl. Fig. 3B), vier Spulen I1, I2, Q1, Q2 einer ersten Spulengruppe (Parallelspulen) und vier Spulen VI1, VI2, VQ1, VQ2 einer zweiten Spulengruppe (Orthogonalspulen). Die erste Spulengruppe umfasst zwei zueinander orthogonal angeordnete Spulenpaare I1, I2 bzw. Q1, Q2, die im erweiterten Wickelzylinder der ersten Hauptspule B_{L}, etwa vollständig bzw. zum überwiegenden Teil im Innenraum der ersten Hauptspule B_{L} angeordnet sind. Die Spulen I1, I2, Q1, Q2 der ersten Spulengruppe sind mit gleicher Windungsebene, in einem Winkelabstand von jeweils 90° und gleichabständig zur Achse der Hauptspule B_{L} angeordnet.

Wie in der Fig. 3B vereinfacht dargestellt, durchflutet ein von der Hauptspule B_{L} erzeugtes Erregerfeld 3 einen zu untersuchenden Untergrund U und in diesem eingebettete Messobjekte von oben und in senkrechter Richtung zur Oberfläche des Untergrunds. Der Durchmesser der ersten Hauptspule B_{L}, die relativ groß und flach ausgestaltet sein kann, beträgt beispielshalber etwa 90mm. Bei einer Windungszahl von etwa 130 und einer Spulendicke von 8mm ergibt sich eine Induktivität von etwa 3 mH. Aufgrund ihrer Größe ist die erste Hauptspule B_{L} zur Detektion von tiefen Objekten (z.B. Tiefe > 120 mm) geeignet. Die erste Hauptspule B_{L} löst jedoch oberflächennahe Objekte unter Umständen unzureichend auf und es lässt sich nur eine relativ schlechte Separation insbesondere oberflächennaher Objekte erzielen. Die erste Hauptspule B_{L} wird vorzugsweise monostatisch betrieben, d.h. sie fungiert sowohl als Erreger- als auch als Empfängerspule.

Gemäß Fig. 3C sind die zwei im Innenraum der ersten Hauptspule B_{L} zueinander orthogonal angeordneten Spulenpaare I1, I2 bzw. Q1, Q2 beispielsweise so verschaltet, dass ihre Erregerströme zueinander gegensinnig verlaufen, woraus zwischen den Spulen des jeweiligen Spulenpaares I1, I2 bzw. Q1, Q2 eine zur Sensormessfläche SO im Wesentlichen parallele magnetische Durchflutung 33 des Untergrunds U resultiert. Die Durchflutung 33 durch die Parallelspulen erfolgt also nicht von oben, sondern - bezogen auf die Messobjekte - seitlich und zwar in zwei verschiedenen, zueinander orthogonalen Richtungen, welche einerseits dem Spulenpaar I1, I2 und andererseits dem Spulenpaar Q1, Q2 zugeordnet sind. Die Spulen I1, I2, Q1, Q2 der ersten Spulengruppe werden sowohl monostatisch als auch bistatisch betrieben.

Im monostatischen Betrieb ermöglichen die Spulen der ersten Spulengruppe bis zu einer gewissen Messtiefe (z.B. bis etwa 80 mm) deutlich verbesserte Separationseigenschaften bei der Lokalisierung von eingebetteten Objekten, bzw. bei der Auflösung benachbarter Objekte. Insbesondere lassen sich mit dieser Spulenanordnung Stäbe von verschweißten Gittern lokalisieren, da hier das Gitter im Wesentlichen von der Seite durchflutet wird, so dass in den Maschen des Gitters nur in einem geringen Maße Wirbelströme generiert werden. Aufgrund der unterschiedlichen Durchflutungsrichtungen ermöglicht die Kombination der Spulen B_{L}, I1, I2 und Q1, Q2 Mess- und Auswerteverfahren, die verschweißte Gitter sowie permeable Untergrundmaterialien gut zu erkennen vermögen. Beispielsweise kann die Erkennung permeabler Untergrundmaterialien bei Abwesenheit von metallischen Objekten eine Kalibrierungsmessung und damit eine Nullung der Messsignale initiieren. Wird anhand einer typischen Signalsignatur ein Gitter erkannt, so kann die Lokalisierung der Gitterstäbe ausschließlich mit den monostatisch betriebenen verschalteten Spulenpaaren I1, I2 und Q1, Q2 der ersten Spulengruppe vorgenommen werden, da deren Durchflutungsart keine bzw. nur geringe Wirbelströme in den Maschen induziert. Mit den unterschiedlichen Durchflutungsrichtungen, die diese Spulenanordnung ermöglicht, lassen sich verschweißte Gitter und permeable Untergründe erkennen, Gitterstäbe lokalisieren und sehr präzise Resultate bei der Überdeckungsmessung erreichen.

In einem ersten bistatischen Betrieb wird die Hauptspule B_{L} mit einem Erregerstrom beaufschlagt ("bestromt") während der in den Spulen I1, I2, Q1, Q2 der ersten Spulengruppe ("Parallelspulen") induzierte Strom gemessen ("ausgelesen") wird. Die Messtiefe ist dabei erheblich höher als beim monostatischen Betrieb, so dass neben der Information der Hauptspule B_{L} zusätzliche Informationen bei der Detektion von tiefen Objekten (Tiefe > 80 mm) zur Verfügung stehen.

Ein zweiter bistatischer Betrieb, bei dem jeweils ein Spulenpaar bestromt und das andere ausgelesen wird, ("Spulen I1, I2 bestromen - Spulen Q1, Q2 auslesen" bzw. "Spulen Q1, Q2 bestromen - Spulen I1, I2 auslesen") liefert Information über die Orientierung der eingebetteten Objekte bezogen auf die Orientierung der Spulenanordnung bzw. des Sensors.

Bei der soweit beschriebenen Spulenanordnung sind die Separationseigenschaften noch abhängig von der Orientierung der eingebetteten Messobjekte. Falls Messobjekte in Richtung des Spulenpaares I1, I2 oder des Spulenpaares Q1, Q2 orientiert sind, so sind die Separations- und Lokalisierungseigenschaften ideal, während bei eine Orientierung von 45° mehr oder weniger nur dasselbe Ergebnis wie bei der Verwendung der Hauptspule B_{L} allein erreicht wird. Um insgesamt eine optimale Messgenauigkeit zu erzielen, muss die Vorzugsrichtung eines Objekts zusätzlich detektiert werden, was in schwierigen Fällen, z.B. bei gekreuzten Objekten, mit der bisher beschriebenen Spulenanordnung noch nicht zuverlässig möglich ist.

Eine deutliche Verbesserung der Separationseigenschaften wird mit den Spulen ("Orthogonalspulen") der zweiten Spulengruppe erzielt, die ebenfalls im erweiterten Wickelzylinder der ersten Hauptspule B_{L}, etwa vollständig bzw. zum überwiegenden Teil im Innenraum der ersten Hauptspule B_{L} angeordnet sein können. Die zweite Spulengruppe umfasst mindestens ein Spulenpaar deren Windungsebenen in einem anderen Winkel zur Windungsebene der ersten Hauptspule B_{L} geneigt sind als die Windungsebene der Spulen der ersten Spulengruppe.

Wie in der Fig. 3A gezeigt, können die Windungsebenen der Spulen VI1, VI2, VQ1, VQ2 der zweiten Spulengruppe senkrecht zu den Windungsebenen der Spulen I1, I2, Q1, Q2 der ersten Spulengruppe und damit in diesem Fall auch senkrecht zur Windungsebene der ersten Hauptspule B_{L} stehen, wobei bevorzugt die Spulen eines Spulenpaares jeweils an der Hauptachse der Hauptspule B_{L} gegenüberliegend angeordnet sind. Die Spulen der zweiten Spulengruppe ("Orthogonalspulen") können bistatisch betrieben werden, wobei die erste Hauptspule B_{L} die Erregerspule ist. Aufgrund des geringen gegenseitigen Abstandes der Spulen, deren orthogonalen, symmetrischen Orientierung und der Kombinierbarkeit der mit den Spulen abgreifbaren Messsignale liefert eine Spulenanordnung mit erster Hauptspule B_{L}, einer ersten Spulengruppe mit vier Spulen I1, I2, Q1, Q2 ("Parallelspulen") und einer zweiten Spulengruppe mit vier um die vertikale Achse eng beabstandet angeordneten Spulen VI1, VI2, VQ1, VQ2 ("Orthogonalspulen") unabhängig von der Orientierung eingebetteter metallischer Objekte gute Separationseigenschaften und damit deren zuverlässige Lokalisierung bis zu einer gewissen Messtiefe, die kleiner ist als die Messtiefe, die mit der ersten Hauptspule B_{L} grundsätzlich erreichbar wäre, z. B. bis zu einer Messtiefe kleiner etwa 120 mm.

Entsprechend der Fig. 3A kann die Sensoranordnung daher weiter eine zweite Hauptspule B_{U} aufweisen, die z.B. rotationssymmetrisch, z.B. als rotationssymmetrische Flachspule ausgeführt sein kann. Der Durchmesser der zweiten Hauptspule B_{U}, die in diesem Ausführungsbeispiel gemäß Fig. 3B bezogen auf die Bewegungsoberfläche des Sensors oberhalb der ersten Hauptspule B_{L} angeordnet ist, kann geringfügig kleiner oder größer sein als der der ersten Hauptspule B_{L}, Mit der zweiten Spulenebene wird die Genauigkeit einer Überdeckungsmessung weiter erhöht, insbesondere bei der Detektion vergleichsweise tief (z.B. Tiefe > 120 mm) im Untergrund eingebetteter Objekte.

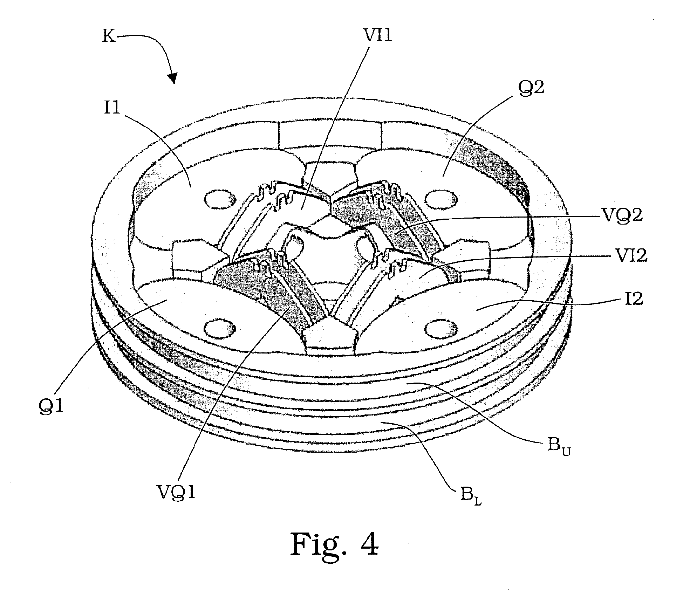

Die Fig. 4 zeigt in perspektivischer Darstellung einen Spulenkörper K für eine erste und zweite Hauptspule B_{L}, B_{U}, einer Spulenanordnung gemäß Fig. 3A. Der ein- oder mehrteilige Spulenkörper K ist weiter zur Aufnahme von vier parallel zu den Hauptspulen B_{L}, B_{U} ausgerichteten Spulen I1, I2, Q1, Q2 einer ersten Spulengruppe und von vier orthogonal zu den Hauptspulen ausgerichteten Spulen VI1, VI2, VQ1, VQ2 einer zweiten Spulengruppe ausgebildet.

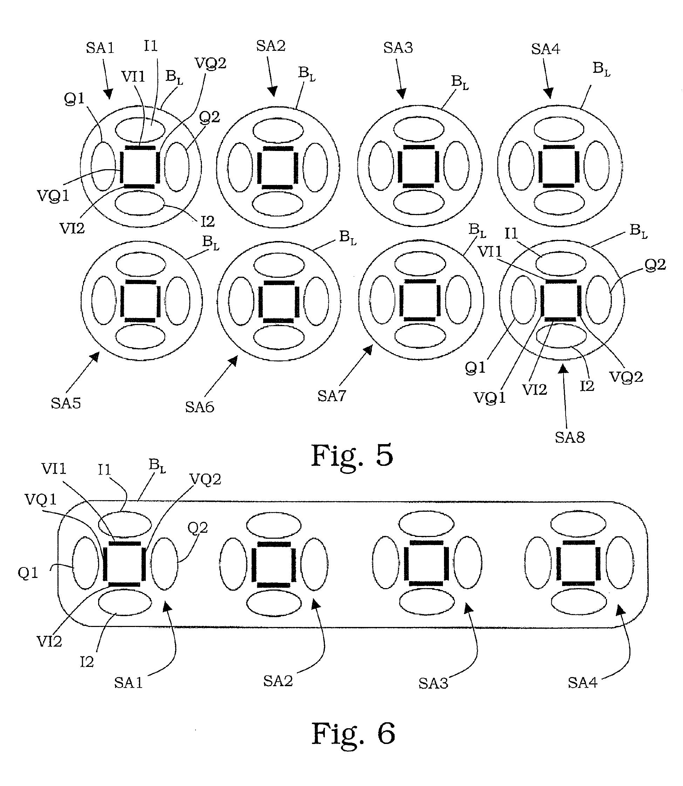

Zur weiteren Verbesserung der Separationseigenschaften sowie der Erkennung der Orientierung von Messobjekten in Untergründen kann die Spulenanordnung gemäß der Fig. 3A als ganzes oder in Teilen vervielfacht werden. Ausführungsbeispiele dazu sind die in den Fig. 5 bis 7 dargestellten Anordnungen.

Bei der Anordnung nach Fig. 5 sind acht Spulenanordnungen SA1-SA8 in zwei parallelen Reihen nebeneinander angeordnet. Jede Spulenanordnung SA1-SA8 umfasst mindestens eine Hauptspule B_{L}, vier Spulen I1, I2, Q1, Q2 einer ersten Spulengruppe und vier Spulen einer zweiten Spulengruppe VI1, VI2, VQ1, VQ2 entsprechend der Fig. 3A. Anstelle von acht kann die Anordnung zwei, vier, sechs oder mehr als acht Spulenanordnungen nach Fig. 3A umfassen. Alle Spulenanordnungen SA1-SA8 können auch jeweils eine zweite Hauptspule B_{U} nach Fig. 3A aufweisen..

Die Anordnung nach Fig. 6 umfasst vier gleichartige Gruppen SA1 bis SA4 mit jeweils vier Spulen I1, 12, Q1, Q2 einer ersten Spulengruppe und vier Spulen einer zweiten Spulengruppe VI1, VI2, VQ1, VQ2 entsprechend der Fig. 3A. Die vier Gruppen SA1 bis SA4 sind in einer Reihe angeordnet, die von einer ersten Hauptspule BL umschlossen ist. Gemäß anderen Ausführungsformen wird die Reihe zusätzlich von einer zweiten Hauptspule umschlossen, die etwas kleiner oder größer als die erste Hauptspule ist.

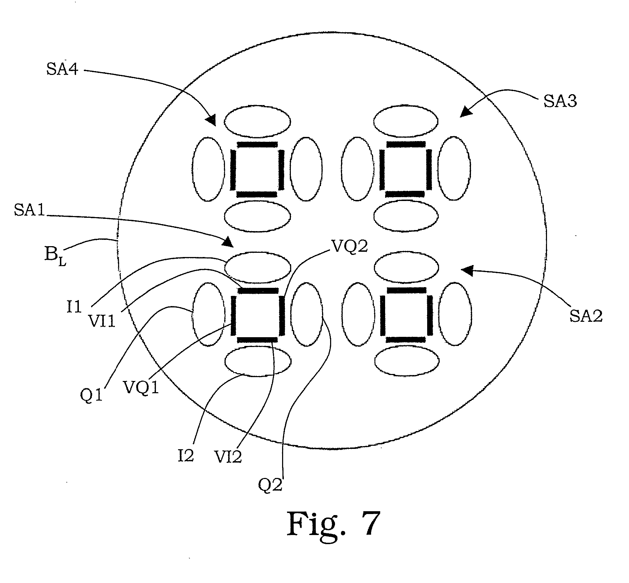

Bei der Ausführungsform nach Fig. 7 ist ein Quartett von Gruppen von jeweils vier Spulen I1, I2, Q1, Q2 einer ersten Spulengruppe und vier Spulen einer zweiten Spulengruppe VI1, VI2, VQ1, VQ2 entsprechend der Fig. 3A ebenfalls durch eine erste Hauptspule B_{L} umschlossen.

Der bevorzugte Betrieb und die sich daraus ergebenden Vorteile der Erfindung werden nachfolgend beschrieben:

Zur erfindungsgemäßen Spulenanordnung gehört mindestens eine bei einem Messvorgang horizontal liegende Hauptspule B_{L} deren Magnetfeld eingebettete Messobjekte von oben (senkrecht) durchflutet, wobei sich eine große Messtiefe erreichen lässt. Diese Hauptspule B_{L} wird sowohl monostatisch als auch, in Verbindung mit weiteren Spulen bistatisch betrieben, um für einen schmalen Lokalisierungsbereich zusätzliche Informationen für eine genaue Überdeckungsmessung zu erhalten. Die Hauptspule B_{L} ist rotationssymmetrisch gestaltet (zweiachsige Symmetrie) und damit orientierungsunabhängig.

Die Spulenanordnung umfasst in vorteilhafter Ausführungsform vier weitere parallel zur Windungsebene der Hauptspule angeordnete, in Gegenüberstellung und senkrecht zueinander ausgerichtete kleinere Spulenpaare I1, I2 bzw. Q1, Q2 welche paarweise zusammengeschaltet sind, sodass deren Magnetfelder die Messobjekte seitlich aus unterschiedlichen Richtungen durchfluten. Damit lassen sich gute Separationseigenschaften und eine zuverlässige Messung insbesondere auf verschweißten Metallgittern erzielen.

Die Paare der kleineren horizontalen Spulen sind also orthogonal zueinander orientiert und werden bei einem bevorzugten Messverfahren monostatisch betrieben, so dass zusammen mit der Hauptspule B_{L} drei orthogonale Durchflutungsrichtungen möglich sind. Die Messgenauigkeit der Überdeckungsmessung und das Separationsvermögen werden deutlich verbessert, und eine zuverlässige Erkennung von verschweissten Gittern, leitfähigen Nicht-Eisenobjekten und ferritischen Untergründen kann gewährleistet werden. Bei der Erkennung von ferritischen Untergründen ist es vorteilhaft, zunächst mit einer Kalibrierungsmessung zu starten, um deren Einfluss zu eliminieren.

Vorteilhafterweise sind die Parallelspulen oval gestaltet, wodurch das Empfangssignal bei besserer Flächenausnutzung vergrößert wird. Die Abhängigkeit eines aus den Spulenpaaren I1, I2 bzw. Q1, Q2 der ersten Spulengruppe generierten Summensignals (I + Q) vom Winkel zu den eingebetteten Objekten bzw. von der Orientierung des eingebetteten Objekts ist reduziert.

Weitere Informationen zur Verbesserung der Zuverlässigkeit bei einer Lokalisierung und Überdeckungsmessung lassen sich erzielen, wenn die Spulenpaare I1, I2 bzw. Q1, Q2 bistatisch betrieben werden, wobei die äußere Spule B_{L}. bestromt und über die Spulenpaare I1, I2 und/oder Q1, Q2 ausgelesen wird.

Eine verbesserte Aussage über die Winkelorientierung von Messobjekten bezogen auf die Orientierung des Sensorkopfes lässt sich erreichen, wenn in einem Messdurchlauf die horizontalen Spulenpaare I1, I2 bzw. Q1, Q2 bistatisch betrieben werden, gemäß den Alternativen "I1, I2 bestromen - Q1, Q2 auslesen" bzw. "Q1, Q2 bestromen - I1, I2 auslesen". Um Messzeit einzusparen kann auch vorgesehen werden, die beiden horizontalen Spulenpaare I1, 12 bzw. Q1, Q2 gleichzeitig zu bestromen. Aufgrund der Orthogonalität beeinflusst die Bestromung eines Parallelspulenpaares das andere Parallelspulenpaar kaum, so dass die sequenzielle Bestromung und die gleichzeitige Bestromung gleiche Effekte implizieren.

Um insbesondere eine Lokalisierung etwa bei einer 45°-Orientierung der Messobjekte bezogen auf den Sensorkopf zur erhöhen, den Lokalisierungsbereich einzuengen und die Messgenauigkeit durch eine Zusatzinformation zu erhöhen, umfasst eine erfindungsgemäße Spulenanordnung einen weiteren Satz von vertikal dicht beieinander liegend angeordneten Spulen, vorteilhafterweise in symmetrischer Anordnung von vier senkrecht zueinander stehenden Orthogonalspulen. Die Signale dieser Orthogonalspulen werden für die Orientierungsmessung in bestimmter Weise kombiniert.

Um eine ausreichende Messtiefe und Orientierungsunabhängikeit zu gewährleisten, ist es vorteilhaft die vertikal angeordneten Spulen bistatisch zu betreiben gemäß "B_{L} bestromen - VI1, VI2 bzw. VQ1, VQ2 auslesen".

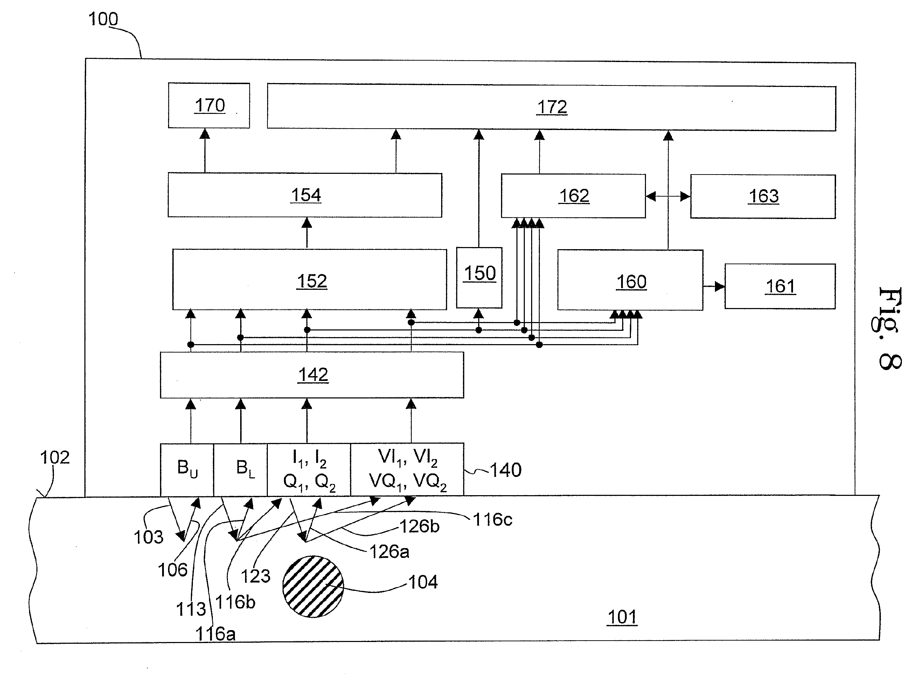

Anhand des Flussdiagramms in Fig. 8 und der Übersicht der Mess- und Spulenbetriebsarten in Tabelle 1 wird das Mess- und Auswerteverfahren näher erläutert. Der Sensor 100 liegt mit einer Bewegungsoberfläche auf einer Oberfläche 102 eines Untergrunds 101 auf, in dem ein permeables Objekt 104 eingebettet ist. Der Sensor 100 weist eine Spulenanordnung 140 auf, die eine erste und eine zweite Hauptspule B_{L}, B_{U}, vier Spulen I1, I2, Q1, Q2 (Parallelspulen) einer ersten Spulengruppe und vier Spulen VI1, VI2, VQ1, VQ2 (Orthogonalspulen) einer zweiten Spulengruppe umfasst. Die zweite Hauptspule B_{U} wird monostatisch betrieben, d.h. Erregung 103 und Empfang 106 erfolgen mit derselben Spule. Diese Spule wird nur für die Überdeckungsmessung verwendet. Die erste Hauptspule B_{L} arbeitet sowohl monostatisch (Erregung 113, Empfang 116a) als auch bistatisch, wobei der bistatische Betrieb durch Bestromung von B_{L} (Erregung 113) und Auslesen der Orthogonalspulen VI1, VI2, VQ1, VQ2 (Empfang 116c) bzw. der Parallelspulenpaare I1, I2 und Q1, Q2 (Empfang 116b) gekennzeichnet ist. Die Parallelspulenpaare I1, I2 und Q1, Q2 werden zusätzlich monostatisch (Erregung 123, Empfang 126a) betrieben, da hier - wie oben beschrieben - die parallelen Durchflutungsrichtungen für die Erkennung von verschweißten Gittern und permeablen Untergründen sowie für die Lokalisierung von Gitterstäben von Bedeutung sind.

Die Signale der Spulenanordnung 140 werden auf einen Signalkonditionierer 142 geführt. Hier werden die jeweiligen Signale verstärkt, gefiltert, intervallweise integriert und mit Kalibrierungssignalen verrechnet, wobei eine analoge Verarbeitung und/oder eine digitale Verarbeitung mittels Mikroprozessor zum Einsatz kommt. Die verarbeiteten Signale gelangen anschließend auf einen Entscheider 152, der anhand der Signalsignaturen den optimalen Algorithmus für die Lokalisierung auswählt. Der Gittermodus für verschweißte Gitter wird anhand der Signale der ersten Hauptspule B_{L} zusammen mit den monostatischen Signalen der Parallelspulenpaare I1, I2 und Q1, Q2 ermittelt. Der Tiefenmodus für sehr tief liegende Objekte (> 120 mm) sowie der Präzisionsmodus für eine sehr genaue Lokalisierung bei vergleichsweise geringen Tiefen (< 120 mm) werden anhand der Signale der ersten Hauptspule B_{L} in Verbindung mit den bistatischen Signalen der Orthogonalspulen VI1, VI2, VQ1, VQ2 bestimmt.

Der Lokalisierer 154 erkennt die Position eingebetteter metallischer Objekte und zeigt sie optisch an, beispielsweise durch Einschalten einer LED 170, die z.B. rot sein kann, oder auf einem Display 172. Im Gittermodus erfolgt die Lokalisierung mit den monostatischen Signalen der Parallelspulenpaare I1, I2 und Q1, Q2, da sie - wie erwähnt - die optimal angepassten Durchflutungsrichtungen aufweisen.
Im Tiefenmodus werden die Objekte mit Hilfe des monostatischen Signals der ersten Hauptspule B_{L} und der bistatischen Empfangssignale der Parallelspulenpaare I1, I2 und Q1, Q2 (Bestromung auf B_{L}) lokalisiert, da diese Signale für große Tiefen (> 120 mm) geeignet sind. Im Präzisionsmodus erfolgt die Lokalisierung mit den bistatischen, in vorteilhafter Weise kombinierten Empfangssignalen der Orthogonalspulen VI1, VI2, VQ1, VQ2 (Bestromung auf B_{L}), da sie aufgrund ihrer Anordnung und ihres geringen Abstands eine orientierungsunabhängige und zuverlässige Lokalisierung mit guten Separationseigenschaften ermöglichen. Zur weiteren Verbesserung der Separationseigenschaften bei geringen Tiefen (< 80 mm) werden zusätzlich die monostatischen Signale der Parallelspulenpaare I1, I2 und Q1, Q2 ausgewertet.

Letztere werden außerdem auf einen Winkelschätzer 150 gegeben, der mit diesen Signalen die Orientierung der eingebetteten Objekte 104 bestimmt und auf dem Display 172 darstellt. Des Weiteren werden die Ausgangssignale des Signalkonditionierers 142 auf den Überdeckungsschätzer 162 geführt, der mit Hilfe einer Wissensbasis 163 die Tiefe der Objekte 104 ermittelt. Dabei werden alle möglichen Signalkombinationen verwendet, was eine hohe Redundanz und damit eine hohe Zuverlässigkeit zur Folge hat. Die Signale der ersten und zweiten Hauptspule B_{L}, B_{U} werden ratiometrisch verrechnet, d.h. sie werden ins Verhältnis gesetzt, so dass Störungen, die auf beiden Ebenen ähnlich wirken, reduziert werden. Dieses Verhältnis wird insbesondere zur akkuraten Überdeckungsschätzung bei sehr tiefen Objekten (> 120 mm) benötigt, wenn die anderen Komponenten der Spulenanordnung 140 keine brauchbaren Signale mehr liefern. Die Objekttiefe wird auf dem Display 172 dargestellt. Darüber hinaus werden die Ausgangssignale des Signalkonditionierers 142 auf den Klassifizierer 160 geführt. Hier wird mit den monostatischen Signalen der Parallelspulenpaare I1, I2 und Q1, Q2 und dem monostatischen Signal der Spule B_{L} mit einem Klassifizierungsalgorithmus zwischen Eisen, Nicht-Eisen und permeablen Untergründen unterschieden. Die Materialkennung wird auf dem Display 172 angezeigt. Bei der Erkennung von permeablen Untergründen wird durch eine Kalibriereinheit 161 eine Kalibrierungsmessung initiiert, mit der eine Nullung der Messsignale durchgeführt wird. Eine Kalibrierungsmessung wird ebenfalls vorgenommen, wenn der Klassifizierer kein metallisches Objekt in der Nähe des Sensors wahrnimmt. Die Bestromungszeiten liegen je nach Spulenanordnung im Bereich von 0,3 ms bis 0,5 ms. Danach wird die Wirbelstromantwort des eingebetteten metallischen Objektes in einem etwa 1 ms weiten Zeitfenster aufgenommen.

Zur Lokalisierung und Klassifizierung werden folgende Sequenzen betrieben: Zunächst wird die erste Hauptspule B_{L} bestromt und zusammen mit den Parallelspulen und Orthogonalspulen ausgelesen. Dann werden die Parallelspulen bestromt und ausgelesen.

Zur genauen Überdeckungsschätzung kann zusätzlich eine Sequenz verwendet werden, im Zuge derer die zweite Hauptspule B_{U} bestromt und ausgelesen wird. Natürlich ist es auch denkbar, anstelle der ersten Hauptspule B_{L} die zweite Hauptspule B_{U} zu bestromen und die Parallelspulen und Orthogonalspulen auszulesen. Dies hat aber im Vergleich zu der oben beschriebenen bevorzugten Variante (Bestromung auf B_{L}) Performance-Einbußen hinsichtlich der Messtiefe zur Folge.

Die Zusatzinformation zur Lokalisierung und Überdeckungsmessung von Objekten wird zuverlässiger, wenn gemäß einer weiteren Ausführungsvariante der Erfindung die Parallelspulenpaare I1, I2 und / oder Q1, Q2 bestromt und die Orthogonalspulen VI1, VI2, VQ1, VQ2 ausgelesen werden. Dieser Betrieb ist in Fig. 8 durch den zweiten Pfeil auf die Orthogonalspulensektion angedeutet. Diese Messung liefert eine weitere Signalsignatur, die der Überdeckungsschätzer 162 in Verbindung mit einer weiteren Wissensbasis 163 verwenden kann. Da diese Signalsignatur sich von den anderen stark unterscheidet, werden die Redundanz und damit die Zuverlässigkeit der Überdeckungsschätzung wesentlich erhöht. Stark unterschiedliche Signalsignaturen sind "B_{L} bestromen - B_{L} auslesen", "Parallelspulen bestromen - Parallelspulen auslesen", "B_{L} bestromen - Orthogonalspulen auslesen", und "Parallelspulen bestromen - Orthogonalspulen auslesen". Andere Kombinationen bringen keinen wesentlichen Verbesserungen bei der Überdeckungsschätzung.

Zur genauen Überdeckungsschätzung werden daher bei dieser Ausführungsvariante folgende drei Sequenzen bevorzugt: Zunächst wird die erste Hauptspule B_{L} bestromt und zusammen mit den Orthogonalspulen ausgelesen.

Dann werden die Parallelspulen bestromt und zusammen mit den Orthogonalspulen ausgelesen. Schließlich wird die zweite Hauptspule B_{U} bestromt und ausgelesen.

Die Zuverlässigkeit einer Überdeckungsmessung wird weiter erhöht, wenn gemäß einer verbesserten Spulenanordnung der Erfindung eine zweite höher angeordnete Ebene für die Parallelspulen vorgesehen wird. Dabei ist es zweckmäßig, zur Verbesserung der Überdeckungsmessung die Messsignale der unteren und der oberen Spulenebene ratiometrisch zu verrechnen, weil Störungen durch in der Nähe liegende Objekte auf beide Ebenen ähnlich wirken und durch Verhältnisbildung eliminiert werden können, wodurch die Messung verbessert wird.

Auch die Verwendung anderer hier nicht näher ausgeführter Kombinationen, z.B. "B_{L} bestromen - B_{U} auslesen" oder "B_{U} bestromen - B_{L} ist denkbar. Zwar können sich die Signalsignaturen stark ähneln; da es sich aber um unabhängige Messungen handelt, ist selbst bei nahezu identischer Signalsignatur eine Rauschreduktion und damit eine - wenn auch im Vergleich mit anderen Kombinationen im geringeren Maße - zuverlässigere Messung möglich.

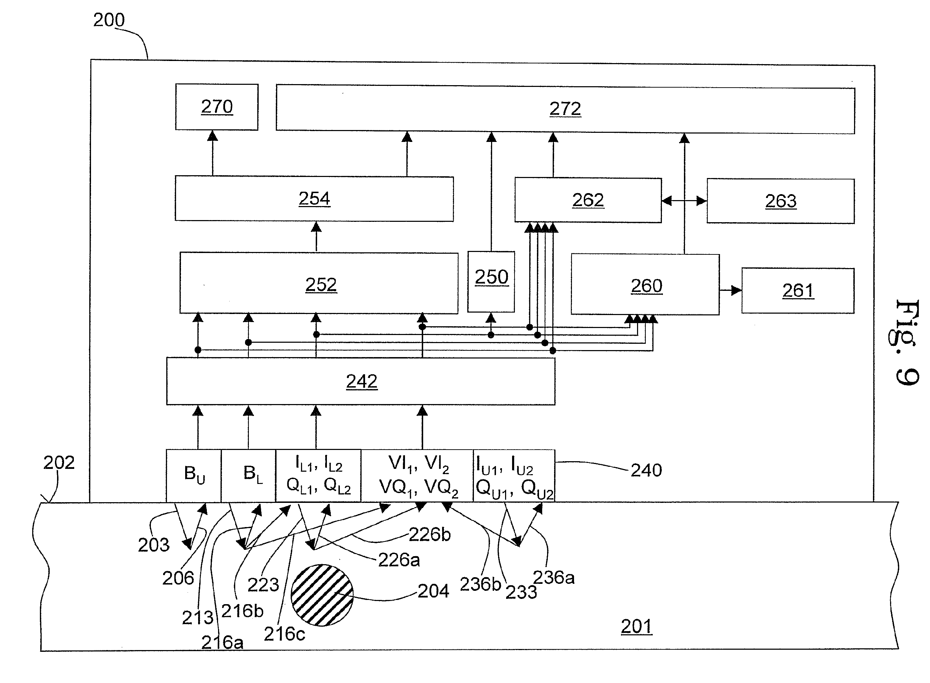

Im in der Fig. 9 dargestellten Ausführungsbeispiel ist die Spulenanordnung der Fig. 8 um eine zweite Ebene von Parallelspulen erweitert. Dabei bezeichnen IL1, IL2 und QL1, QL2 die unteren Parallelspulenpaare und IU1, IU2 und QU1, QU2 die oberen Parallelspulenpaare. Die oberen Parallelspulenpaare werden monostatisch betrieben. Deren Signale werden wie alle anderen Signale einem Signalkonditionierer 242 zugeführt, und die entsprechenden Ausgangssignale werden an den Überdeckungsschätzer 262 übergeben. Die Signale der oberen Parallelspulenpaare und die Signale der unteren Parallelspulenpaare werden ins Verhältnis gesetzt, so dass Störungen, die auf beide Ebenen ähnlich wirken reduziert werden.

Zur genauen Überdeckungsschätzung werden folgende vier Sequenzen bevorzugt: Zunächst wird die erste Hauptspule B_{L} bestromt und zusammen mit den Orthogonalspulen ausgelesen. Dann werden die unteren Parallelspulen bestromt und die unteren Parallelspulen und die Orthogonalspulen ausgelesen. Darauf wird die zweite Hauptspule B_{U} bestromt und ausgelesen. Schließlich werden die oberen Parallelspulen bestromt und zusammen mit den Orthogonalspulen ausgelesen. Die weitere Funktionsweise wurde bereits bei der Erläuterung zur Fig. 8 dargestellt.

Die Tabelle 1 gibt eine Übersicht über die beschriebenen Spulenbetriebsarten.

**Tabelle 1:**

| **Messbetriebsart** | **Spulenbetriebsarten (Bestromung** ⇒ **Auslesen)** |
|---|---|
| Tiefenmodus der Lokalisierung | Erste Hauptspule (B_{L}) ⇒ Erste Hauptspule (B_{L}) |
| | Erste Hauptspule (B_{L}) ⇒ arallelspulenpaare (I1I2, Q1Q2) |
| Präzisionsmodus der Lokalisierung | Erste Hauptspule (B_{L}) ⇒ Erste Hauptspule (B_{L}) |
| | Erste Hauptspule (B_{L}) ⇒ Orthogonalspulen (VI1, VI2, VQ1, VQ2) |
| Gittermodus der Lokalisierung | Erste Hauptspule (B_{L}) ⇒ Erste Hauptspule (B_{L}) |
| | Parallelspulenpaare (I1I2, Q1Q2) ⇒ Parallelspulenpaare (I1I2, Q1Q2) |
| Erkennung von verschweißten Gittern | Erste Hauptspule (B_{L}) ⇒ Erste Hauptspule (B_{L}) |
| | Parallelspulenpaare (I1I2, Q1Q2) ⇒ Parallelspulenpaare (I1I2, Q1Q2) |
| Erkennung permeabler Untergründe | Erste Hauptspule (B_{L}) ⇒ Erste Hauptspule (B_{L}) |
| | Parallelspulenpaare (I1I2, Q1Q2) ⇒ Parallelspulenpaare (I1I2, Q1Q2) |
| Erkennung der Orientierung | Parallelspulenpaare (I1I2, Q1Q2) ⇒ Parallelspulenpaare (I1I2, Q1Q2) |
| Überdeckungsschätzung | Erste Hauptspule (B_{L}) ⇒ Erste Hauptspule (B_{L}) |
| | Zweite Hauptspule (B_{U}) ⇒ Zweite Hauptspule (B_{U}) |
| | Parallelspulenpaare (I1I2, Q1Q2) ⇒ Parallelspulenpaare (I1I2, Q1Q2) |
| | Erste Hauptspule (B_{L}) ⇒ Orthogonalspulen (VI1, VI2, VQ1, VQ2) |

## Patentansprüche

1. Spulenanordnung für einen magnetischen Sensor zur Detektion von metallischen Objekten (4) in einem Untergrundmedium (U) **gekennzeichnet durch**
- eine erste Hauptspule (B_{L}), deren Windungsebene zur magnetischen Durchflutung in senkrechter Richtung relativ zu einer Bewegungsoberfläche des Sensors über dem Untergrundmedium (U) weitgehend parallel zur Bewegungsoberfläche des Sensors ausgerichtet ist,
- mindestens zwei im Innenraum eines erweiterten Wickelzylinders der ersten Hauptspule (B_{L}) angeordnete Spulen (I1, I2 bzw. Q1, Q2) einer ersten Spulengruppe und
- mindestens zwei im Innenraum des erweiterten Wickelzylinders der ersten Hauptspule (B_{L}) angeordnete Spulen (VI1, VI2 bzw. VQ1, VQ2) einer zweiten Spulengruppe, die gegenüber den Spulen (I1, I2 bzw. Q1, Q2) der ersten Spulengruppe eine andere Ausrichtung der Windungsebene besitzen.

2. Spulenanordnung nach Anspruch 1, **dadurch gekennzeichnet, dass** die Spulen (I1, I2 bzw. Q1, Q2) der ersten Spulengruppe von einer Hauptachse der ersten Hauptspule (B_{L}) gleich beabstandet sind.

3. Spulenanordnung nach Anspruch 1, **dadurch gekennzeichnet, dass** die Spulen (VI1, VI2 bzw. VQ1, VQ2) der zweiten Spulengruppe von einer Hauptachse der ersten Hauptspule (B_{L}) gleich beabstandet sind.

4. Spulenanordnung nach Anspruch 1, **dadurch gekennzeichnet, dass** die Windungsebenen der Spulen (VI1, VI2 bzw. VQ1, VQ2) der zweiten Spulengruppe senkrecht zu einer Windungsebene der Spulen (I1, I2 bzw. Q1, Q2) der ersten Spulengruppe ausgerichtet sind.

5. Spulenanordnung nach Anspruch 1, **dadurch gekennzeichnet, dass** die Windungsebene der Spulen (I1, I2 bzw. Q1, Q2) der ersten Spulengruppe parallel zur Windungsebene der ersten Hauptspule (B_{L}) ausgerichtet sind.

6. Spulenanordnung nach Anspruch 1, **dadurch gekennzeichnet, dass** die Windungsebene der Spulen (VI1, VI2 bzw. VQ1, VQ2) der zweiten Spulengruppe senkrecht zur Windungsebene der ersten Hauptspule (B_{L}) ausgerichtet sind.

7. Spulenanordnung nach Anspruch 1, **dadurch gekennzeichnet, dass** die erste Hauptspule (B_{L}) als rotationssymmetrische Flachspule gestaltet ist.

8. Spulenanordnung nach Anspruch 1, **dadurch gekennzeichnet, dass** die erste Spulengruppe vier Spulen (I1, I2, Q1, Q2) gleicher Größe umfasst, die im Winkelabstand von jeweils 90° und gleichabständig zu einer Hauptachse der ersten Hauptspule (B_{L}) angeordnet sind.

9. Spulenanordnung nach Anspruch 8, **dadurch gekennzeichnet, dass** die vier Spulen (I1, I2, Q1, Q2) der ersten Spulengruppe die gleichen Windungsebenen besitzen, die parallel zur Windungsebene der ersten Hauptspule sind.

10. Spulenanordnung nach Anspruch 9, **dadurch gekennzeichnet, dass** jeweils zwei der vier Spulen (I1, I2, Q1, Q2) der ersten Spulengruppe einander gegenüberliegend zu Spulenpaaren angeordnet und elektrisch so verbunden sind, dass die Magnetfelder der beiden Spulenpaare das metallische Objekt (4) seitlich in zwei zueinander orthogonalen Richtungen durchfluten.

11. Spulenanordnung nach Anspruch 9, **dadurch gekennzeichnet, dass** die vier Spulen (I1, I2, Q1, Q2) der ersten Spulengruppe oval gewickelt sind mit jeweils gegenüberliegend paarweise gleicher Ausrichtung der Nebenachse des Spulenovals.

12. Spulenanordnung nach Anspruch 1, **dadurch gekennzeichnet, dass** die zweite Spulengruppe vier Spulen (VI1, VI2, VQ1, VQ2) gleicher Größe umfasst, die im gleichen Abstand zu einer Hauptachse der ersten Hauptspule (B_{L}) zueinander stehen.

13. Spulenanordnung nach Anspruch 12, **dadurch gekennzeichnet, dass** die Windungsebenen der vier Spulen (VI1, VI2, VQ1, VQ2) der zweiten Spulengruppe (VI1, VI2, VQ1, VQ2) jeweils senkrecht zur Windungsebene der ersten Hauptspule (B_{L}) stehen.

14. Spulenanordnung nach Anspruch 13, **dadurch gekennzeichnet, dass** die vier Spulen (VI1, VI2, VQ1, VQ2) der zweiten Spulengruppe innerhalb der Spulen (I1, I2, Q1, Q2) der ersten Spulengruppe mit jeweils gleichem Abstand symmetrisch zur Hauptachse der ersten Hauptspule (B_{L}) angeordnet sind.

15. Spulenanordnung nach einem der vorstehenden Ansprüche, **gekennzeichnet durch** eine zweite Hauptspule (B_{U}) mit einer zur Windungsebene der ersten Hauptspule (B_{L}) parallelen Windungsebene, die relativ zur Bewegungsoberfläche oberhalb der ersten Hauptspule (B_{L}) angeordnet ist.

16. Spulenanordnung nach Anspruch 15, **dadurch gekennzeichnet, dass** der Durchmesser der zweiten Hauptspule (B_{U}) kleiner oder größer ist als der Durchmesser der ersten Hauptspule (B_{L})_{.}

17. Spulenanordnung nach einem der vorstehenden Ansprüche, **gekennzeichnet durch** eine Reihenanordnung mehrerer der Spulenanordnungen gemäß einem der vorstehenden Ansprüche.

18. Spulenanordnung nach einem der Ansprüche 1 bis 16, **gekennzeichnet durch** eine Reihenanordnung von mehreren, jeweils gleich gruppierten Spulen der ersten und/oder zweiten Spulengruppe, wobei die erste Hauptspule (B_{L}) die Reihenanordnung umschließt.

19. Verfahren zum Betreiben einer Spulenanordnung nach einem der vorstehenden Ansprüche, **dadurch gekennzeichnet, dass** zur Lokalisation tief liegender Objekte die Spulenanordnung monostatisch gemäß "erste Hauptspule bestromen und auslesen" und bistatisch gemäß "erste Hauptspule bestromen und erste Spulengruppe auslesen" betrieben wird.

20. Verfahren zum Betreiben einer Spulenanordnung nach einem der Ansprüche 1 bis 18, **dadurch gekennzeichnet, dass** zur Erkennung von Gittern und von permeablen Untergründen die Spulenanordnung monostatisch gemäß "erste Hauptspule bestromen und auslesen" und monostatisch gemäß "erste Spulengruppe bestromen und erste Spulengruppe auslesen" betrieben wird.

21. Verfahren zum Betreiben einer Spulenanordnung nach einem der Ansprüche 1 bis 18, **dadurch gekennzeichnet, dass** zur Lokalisation von Gitterstäben die erste Spulengruppe monostatisch gemäß "erste Spulengruppe bestromen und erste Spulengruppe auslesen" betrieben wird.

22. Verfahren zum Betreiben einer Spulenanordnung nach einem der Ansprüche 1 bis 18, **dadurch gekennzeichnet, dass** zur präzisen Lokalisierung von metallischen Objekten die Spulenanordnung bistatisch gemäß "erste Hauptspule bestromen und zweite Spulengruppe auslesen" betrieben wird.

23. Verfahren zum Betreiben einer Spulenanordnung nach einem der Ansprüche 15 bis 16, **dadurch gekennzeichnet, dass** zur Überdeckungsmessung von metallischen Objekten die Spulenanordnung monostatisch gemäß "erste Hauptspule bestromen und auslesen" und monostatisch gemäß "zweite Hauptspule bestromen und auslesen" betrieben wird und die beiden Messergebnisse ratiometrisch ausgewertet werden.

24. Verfahren zum Betreiben einer Spulenanordnung nach einem der Ansprüche 1 bis 18, **dadurch gekennzeichnet, dass** zur Überdeckungsmessung von metallischen Objekten die Spulenanordnung monostatisch gemäß "erste Hauptspule bestromen und auslesen" und bistatisch gemäß "erste Hauptspule bestromen und zweite Spulengruppe auslesen" betrieben wird.

25. Verfahren zum Betreiben einer Spulenanordnung nach einem der Ansprüche 1 bis 18, **dadurch gekennzeichnet, dass** zur Überdeckungsmessung von metallischen Objekten die erste Spulengruppe monostatisch gemäß "erste Spulengruppe bestromen und erste Spulengruppe auslesen" betrieben wird.

26. Verfahren zum Betreiben einer Spulenanordnung nach einem der Ansprüche 1 bis 18, **dadurch gekennzeichnet, dass** zur Überdeckungsmessung von metallischen Objekten die erste Spulengruppe bistatisch gemäß "erste Spulengruppe bestromen und zweite Spulengruppe auslesen" betrieben wird.

27. Verfahren zum Betreiben einer Spulenanordnung nach einem der Ansprüche 1 bis 18, **dadurch gekennzeichnet, dass** die erste Spulengruppe mindestens zwei Spulenpaare umfasst und zur Orientierungsmessung von metallischen Objekten die erste Spulengruppe wechselweise bistatisch betrieben wird, mit Bestromung eines der Spulenpaare (I1, I2) und Detektion über ein anderes der Spulenpaare (Q1, Q2) oder vice versa.

28. Verfahren zum Betreiben einer Spulenanordnung nach einem der Ansprüche 1 bis 18, **dadurch gekennzeichnet, dass** der monostatische Betrieb der ersten Spulengruppe durch gleichzeitiges Bestromen und Auslesen der Spulen der ersten Spulengruppe **gekennzeichnet** ist.

29. Verfahren zum Betreiben einer Spulenanordnung nach einem der Ansprüche 8 bis 10, **dadurch gekennzeichnet, dass** der monostatische Betrieb der ersten Spulengruppe durch sequentielles Bestromen und Auslesen der beiden Spulenpaare gemäß im ersten Schritt "Spulenpaar I1, I2 bestromen und Spulenpaar I1, I2 auslesen" und im zweiten Schritt "Spulenpaar Q1, Q2 bestromen und Spulenpaar Q1, Q2 auslesen" oder vice versa **gekennzeichnet** ist.
